(19) Europäisches Patentamt / European Patent Office / Office européen des brevets

(11) **EP 3 767 282 B1**

(12) **FASCICULE DE BREVET EUROPEEN**

(45) Date de publication et mention
de la délivrance du brevet:
**12.02.2025 Bulletin 2025/07**

(21) Numéro de dépôt: **20185506.1**

(22) Date de dépôt: **13.07.2020**

(51) Classification Internationale des Brevets (IPC):
**G01N 21/64** *(2006.01)*   **G01N 21/95** *(2006.01)*
**H01L 21/66** *(2006.01)*   **H02S 50/15** *(2014.01)*

(52) Classification Coopérative des Brevets (CPC):
**H01L 22/20; G01N 21/6408; G01N 21/6489;**
**G01N 21/9501; H01L 22/12; H02S 50/15;**
Y02E 10/50

(54) **DISPOSITIF ET MÉTHODE POUR MESURER IN-SITU LE TEMPS DE VIE DE PORTEURS MINORITAIRES DANS UN MATÉRIAU SEMI-CONDUCTEUR**

VORRICHTUNG UND METHODE ZUR IN-SITU-MESSUNG DER LEBENSDAUER VON MINORITÄTSTRÄGERN IN EINEM HALBLEITERMATERIAL

DEVICE AND METHOD FOR IN-SITU MEASURING THE LIFETIME OF MINORITY CARRIERS IN A SEMICONDUCTOR MATERIAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.07.2019 FR 1908051**

(43) Date de publication de la demande:
**20.01.2021 Bulletin 2021/03**

(73) Titulaires:
• **Centre National de la Recherche Scientifique**
  **75016 Paris (FR)**
• **Institut Photovoltaïque d'Ile de France - IPVF**
  **91120 Palaiseau (FR)**
• **Electricité de France**
  **75008 Paris (FR)**
• **Ecole Polytechnique**
  **91120 Palaiseau (FR)**
• **TotalEnergies OneTech**
  **92400 Courbevoie (FR)**

(72) Inventeurs:
• **ROCA CABAROCCAS, Pere**
  **91128 PALAISEAU CEDEX (FR)**
• **SILVA, François**
  **91240 SAINT-MICHEL-SUR-ORGE (FR)**
• **SRENG, Mengkoing**
  **91120 PALAISEAU (FR)**

(74) Mandataire: **IPAZ**
**Bâtiment Platon**
**Parc Les Algorithmes**
**91190 Saint-Aubin (FR)**

(56) Documents cités:
**US-A1- 2011 117 681    US-A1- 2013 146 787**
**US-A1- 2015 219 560**

• **CHOI KWAN BUM ET AL: "Modulated Photoluminescence Lifetime Measurement of Bifacial Solar Cells", IEEE JOURNAL OF PHOTOVOLTAICS, I E E E, US, vol. 7, no. 6, 1 November 2017 (2017-11-01), pages 1687 - 1692, XP011672003, ISSN: 2156-3381, [retrieved on 20171023], DOI: 10.1109/JPHOTOV.2017.2733163**
• **CHOUFFOT R ET AL: "Modulated photoluminescence as an effective lifetime measurement method: Application to a-Si:H/c-Si heterojunction solar cells", MATERIALS SCIENCE AND ENGINEERING: B, ELSEVIER, AMSTERDAM, NL, vol. 159-160, 15 March 2009 (2009-03-15), pages 186 - 189, XP026109116, ISSN: 0921-5107, [retrieved on 20081119], DOI: 10.1016/J.MSEB.2008.10.038**

• GIESECKE J A ET AL: "Understanding and resolving the discrepancy between differential and actual minority carrier lifetime", JOURNAL OF APPLIED PHYSICS, AMERICAN INSTITUTE OF PHYSICS, US, vol. 113, no. 7, 21 February 2013 (2013-02-21), pages 73706 - 73706, XP012170467, ISSN: 0021-8979, [retrieved on 20130219], DOI: 10.1063/1.4790716

## Description

### Domaine technique :

La présente invention concerne le domaine des semi-conducteurs et plus particulièrement des cellules photovoltaïques et plus particulièrement encore la mesure in-situ du temps de vie des porteurs minoritaires dans des matériaux semi-conducteurs, plus particulièrement des cellules photovoltaïques.

### Technique antérieure :

Il est connu d'étudier les propriétés du matériau composant une cellule photovoltaïque grâce à la mesure de la photoluminescence générée dans la structure de la cellule. Plus précisément, la mesure de la luminescence est utilisée pour étudier la qualité du matériau en déterminant le temps de vie des porteurs de charge minoritaires.

Une cellule photovoltaïque comporte une jonction P-N. Par la suite, on appelle la largeur de bande interdite ou « gap » $E_g$ de la jonction le gap de la couche absorbant le rayonnement lumineux incident. Une cellule tandem est un empilement de deux cellules. Une cellule multi-jonctions est constituée de plusieurs couches minces semi-conductrices et de largeur de bande interdite décroissante.

De par l'amélioration de la qualité du silicium cristallin et à cause de la tendance actuelle à réduire l'épaisseur des plaquettes de silicium, le taux de recombinaison des porteurs minoritaires à la surface des cellules photovoltaïques est devenu le facteur limitant l'efficacité des cellules. Pour cette raison, la propriété de la surface des cellules est un paramètre critique.

La complexité et le nombre de processus interagissant avec la surface des cellules photovoltaïques durant leur fabrication sont devenus si importants (par exemple : texturation de surface, passivation, revêtement AR, encapsulation, co-firing...) que les techniques conventionnelles ex-situ de mesure du temps de vie de porteurs de charges minoritaires ne sont plus satisfaisantes. Afin d'étudier et de comprendre les effets de chaque procédé durant la fabrication d'une cellule photovoltaïque, ces techniques ex-situ consistent à comparer le temps de vie de porteurs de charges minoritaires avant et après chaque étapes du procédé de fabrication. Cependant, cette méthode est longue et complexe car elle nécessite plusieurs lots d'un même échantillon afin d'étudier précisément une seule étape du procédé de fabrication en répétant une même mesure.

De nombreuses méthodes permettant d'étudier in-situ le temps de vie de porteurs minoritaires au sein de matériaux photovoltaïques ont été proposées.

Par exemple, il est connu d'étudier la décroissance de la photo-conductivité en régime micro-onde (voir T.S. Horanyi et al, Appl. Surf. Sci. 63 (1993) 306-311). Cependant, cette technique utilise une forte intensité laser qui n'est pas compatible pour étudier les propriétés des cellules photovoltaïque avec une couche passivation mince, par exemple 5 nm. De plus, la sensibilité de cette méthode décroit lorsque la conductivité du matériau augmente. Enfin, cette méthode n'a pas permis, à ce jour, d'étudier le temps de vie de porteurs minoritaires pour une densité de porteurs spécifique de référence. Un tel résultat est critique car au sein du silicium cristallin, le temps de vie des porteurs minoritaires varie fortement en fonction de la densité de porteurs minoritaires (variation pouvant aller de 100 à 1000 µs voir plus). C'est la raison pour laquelle, dans la communauté photovoltaïque ou électronique, le temps de vie des porteurs minoritaires est présenté pour une densité de porteurs spécifique de référence (par exemple $10^{15}$ cm$^{-3}$ pour une cellule solaire mono-jonction en silicium cristallin). Cela permet de comparer les propriétés des cellules solaires bien qu'elles sont fabriquées par des méthodes différentes ou dans différents laboratoires.

La mesure résolue en temps de la photoluminescence (PL) à partir d'un modèle physique basé sur la décroissance du signal PL permet d'étudier une cellule photovoltaïque in-situ et permet, par exemple, de remonter à une densité de pièges électronique ou de temps de vie de porteurs minoritaires (voir US 2013/122612 A1 ou G.D. Jenkins et al, Proc. SPIE 9226 (2015)). Cependant, à ce jour, cette technique n'a pas permis de déterminer le temps de vie de porteurs minoritaires pour une densité de porteurs spécifique.

Des techniques antérieures pour mesurer de temps de vie des porteurs minoritaires dans les matériaux semi-conducteurs, et en particulier dans les cellules solaires, sont également décrites dans les documents suivants :

- Choi Kwan Bum et al: "Modulated Photoluminescence Lifetime Measurement of Bifacial Solar Cells", IEEE Journal of Photovoltaics, vol. 7, no. 6, 1;
- Chouffot R et al: "Modulated photoluminescence as an effective lifetime measurement method: Application to a-Si:H/c-Si heterojunction solar cells", Materials Science and Engineering: B, ELSEVIER, AMSTERDAM, vol. 159-160; et
- Giesecke J A et al: "Understanding and resolving the discrepancy between differential and actual minority carrier lifetime", Journal of Applied Physics, American Institute of Physics, US vol. 113, no. 7.

Il est également connu de réaliser l'étude d'une cellule photovoltaïque par photoluminescence à l'aide d'une source laser modulée sinusoïdalement en mesurant le déphasage entre l'intensité de la source laser et celle du signal PL (R. Bruggemann et al, J. Non-Cryst. Solids 352 (2006) 188861891), cette technique pouvant être appliquée in-situ. Cependant, à ce jour, cette technique n'a pas permis de déterminer le temps de vie de porteurs minoritaires pour une densité de porteurs spécifique.

En outre, le temps de vie des porteurs minoritaires fourni par cette technique est le temps de vie dit différentiel qui est imprécis.

L'invention vise à pallier certains problèmes de l'art antérieur. A cet effet, un objet de l'invention est une méthode pour mesurer in-situ le temps de vie de porteurs minoritaires dans une cellule photovoltaïque en mesurant un signal de photoluminescence généré par un rayonnement lumineux émis à une pluralité d'intensités moyennes distinctes et modulé successivement à une pluralité de fréquences de modulation distinctes.

**Résumé de l'invention** :

A cet effet, un objet de l'invention est une méthode pour mesurer in-situ le temps de vie de porteurs minoritaires dans un matériau semi-conducteur comprenant au moins une première jonction en mesurant un premier signal de photoluminescence , ladite méthode comprenant :

A. illuminer au moins la première jonction du matériau semi-conducteur avec un premier rayonnement lumineux émis à une pluralité d'intensités moyennes $I1_i$, $i \in [1,m]$ et à une première longueur d'onde adaptée pour générer un premier signal de photoluminescence dans ladite première jonction du matériau semi-conducteur ;

pour chaque $i \in [1,m]$ on réalise les sous-étapes consistant à:

A1- calculer le taux de photogénération $G_i$ de porteurs de charge ;

A2-moduler ledit premier rayonnement lumineux successivement à une pluralité $n>1$ de fréquences de modulation distinctes $\omega_j$ $j \in [1,n]$ et pour chaque $j \in [1,n]$ :

A21-détecter le premier signal de photoluminescence et mesurer le déphasage $\phi_{ij}$ entre une amplitude du premier rayonnement lumineux incident et une amplitude du premier signal de photoluminescence

A3-calculer le temps de vie de porteurs minoritaires $\tau_i$ à partir des mesures dudit déphasage $\phi_{ij}$, avec $j \in [1,n]$;

A4-calculer la densité de porteurs minoritaires $\Delta n_i$ à partir du temps de vie des porteurs minoritaires $\tau_i$ et du taux de photogénération $G_i$;

B. déterminer une fonction continue, dite première fonction, représentative de l'évolution du temps de vie de porteurs minoritaires en fonction de la densité de porteurs minoritaires à partir des valeurs déterminées lors de l'étape A4;

C. calculer une valeur du temps de vie de porteurs minoritaires corrigé pour ladite pluralité d'intensités moyennes, ledit calcul étant effectué à partir de la dérivée de la première fonction, du calcul du temps de vie de porteurs minoritaires et du taux de photogénération;

D. déterminer une fonction continue, dite deuxième fonction, calculant le temps de vie de porteurs minoritaires corrigé en fonction de la densité de porteurs minoritaires, à partir des valeurs du temps de vie de porteurs minoritaires corrigé déterminées dans l'étape C.

Selon des modes particuliers de l'invention :

- le matériau semi-conducteur comprend en outre une deuxième jonction (J2)de largeur de bande interdite supérieure à la largeur de la bande interdite de la première jonction et :

  - l'étape A comprend en outre l'illumination de la deuxième jonction, avec un deuxième rayonnement lumineux ($L2_{in}$) à une deuxième longueur d'onde adaptée pour générer un deuxième signal de photoluminescence (PL2) dans ladite deuxième jonction du matériau semi-conducteur;
  - l'étape A21 comprend en outre la détection, ledit deuxième signal de photoluminescence et la mesure de l'intensité du deuxième signal de photoluminescence.

- la deuxième longueur d'onde est inférieure à la première longueur d'onde et le deuxième rayonnement lumineux est absorbé par la deuxième jonction du matériau semi-conducteur alors que le premier rayonnement lumineux traverse la deuxième jonction pour être absorbé par la première jonction ;

- au moins les étapes A à A4 sont répétées plusieurs fois pendant un procédé de traitement du matériau semi-conducteur ;

Un autre objet de l'invention est un dispositif pour mesurer in-situ le temps de vie de porteurs minoritaires dans un matériau semi-conducteur comprenant au moins une première jonction en mesurant un premier signal de photoluminescence, ledit dispositif comprenant :

- au moins une première source laser émettant un premier rayonnement lumineux à une première longueur d'onde, configurée pour émettre un rayonnement laser à une pluralité d'intensités moyennes distinctes $I1_i$ avec $i \in [1,m]$ et configurée pour être modulé successivement à une pluralité de fréquences de modulation distinctes $\omega_j$ avec $j \in [1,n]$ et configurée pour illuminer une première jonction du matériau semi-conducteur de manière à générer un premier signal de photoluminescence dans ladite première jonction du matériau semi-conducteur;

- un système de détection relié à ladite première source laser, adapté pour détecter le premier signal de photoluminescence et mesurer des déphasages $\phi_{ij}$, entre l'amplitude de chaque premier rayonnement lumineux incident d'intensité $I1_i$ et de fréquence de modulation $\omega_j$ et l'ampltiude du premier signal de photoluminescence associé;

- une unité de traitement reliée au système de détection adaptée pour :

  - calculer, pour chaque intensité moyenne distincte $I1_i$ du premier rayonnement lumineux, le taux de photogénération $G_i$ de porteurs de charge minoritaires;
  - calculer, pour chaque intensité moyenne $I1_i$ distincte du premier rayonnement lumineux , le temps de vies de porteurs minoritaires $\tau_i$ à partir des mesures du déphasage $\phi_{ij}$;
  - calculer, pour chaque intensité moyenne $I1_i$ distincte du premier rayonnement lumineux , la densité de porteur minoritaires $\Delta n_i$ à partir du temps de vie des porteurs minoritaires $\tau_i$ et du taux de photogénération $G_i$;

- ajuster une fonction continue, dite première fonction, calculant le temps de vie des porteurs minoritaires en fonction de la densité de porteurs minoritaires pour la pluralité d'intensités moyennes distinctes du premier rayonnement lumineux;

- calculer des valeurs du temps de vie de porteurs minoritaires corrigé, ledit calcul étant effectué à partir de la dérivée de la première fonction, du calcul du temps de vie de porteurs minoritaires et du taux de photogénération;

- déterminer une fonction continue, dite deuxième fonction, calculant le temps de vie de porteurs minoritaires corrigé en fonction de la densité de porteurs minoritaires à partir des valeurs du temps de vie de porteurs minoritaires corrigé calculées.

Selon des modes particuliers de l'invention :

- le système de détection comprend au moins un amplificateur à détection synchrone ;
- le dispositif comprend une deuxième source laser émettant un deuxième rayonnement lumineux à une deuxième longueur d'onde, ladite deuxième source laser étant configurée pour illuminer une deuxième jonction du matériau semi-conducteur, de largeur de bande interdite supérieure à la largeur de la bande interdite de la première jonction et pour générer un deuxième signal de photoluminescence dans ladite deuxième jonction du matériau semi-conducteur ; et

- un composant optique séparateur adapté pour séparer spatialement le premier signal de photoluminescence et le deuxième signal de photoluminescence ; ledit système de détection étant en outre configuré pour détecter ledit deuxième signal de photoluminescence et mesurer l'intensité du deuxième signal de photoluminescence ;
- la première source et la deuxième source laser sont configurées de manière à ce que la deuxième longueur d'onde soit inférieure à la première longueur d'onde et le deuxième rayonnement lumineux soit absorbé par la deuxième jonction du matériau semi-conducteur alors que le premier rayonnement lumineux traverse la deuxième jonction pour être absorbé par la première jonction ;
- le système de détection comprend au moins un photodétecteur.

**Brève description des figures** :

D'autres caractéristiques, détails et avantages de l'invention ressortiront à la lecture de la description faite en référence aux dessins annexés donnés à titre d'exemple et qui représentent, respectivement :

[Fig.1] une vue schématique d'un dispositif selon l'invention pour mesurer in-situ le temps de vie de porteurs minoritaires dans une cellule photovoltaïque.

[Fig.2] une méthode selon l'invention pour mesurer in-situ le temps de vie des porteurs minoritaires dans une cellule photovoltaïque.

[Fig.3] une méthode pour mesurer in-situ le temps de vie des porteurs minoritaires dans une cellule photovoltaïque, selon une variante de l'invention.

[Fig.4] un graphique représentant respectivement le temps de vie des porteurs de charge minoritaires et le temps de vie des porteurs de charge minoritaires corrigé en fonction de la densité de porteurs de charge minoritaires.

[Fig.5] une vue schématique d'un dispositif pour mesurer in-situ le temps de vie des porteurs minoritaires dans une cellule photovoltaïque multi-jonctions selon un mode de réalisation de l'invention.

Dans les figures, sauf contre-indication, les éléments ne sont pas à l'échelle.

**Description détaillée** :

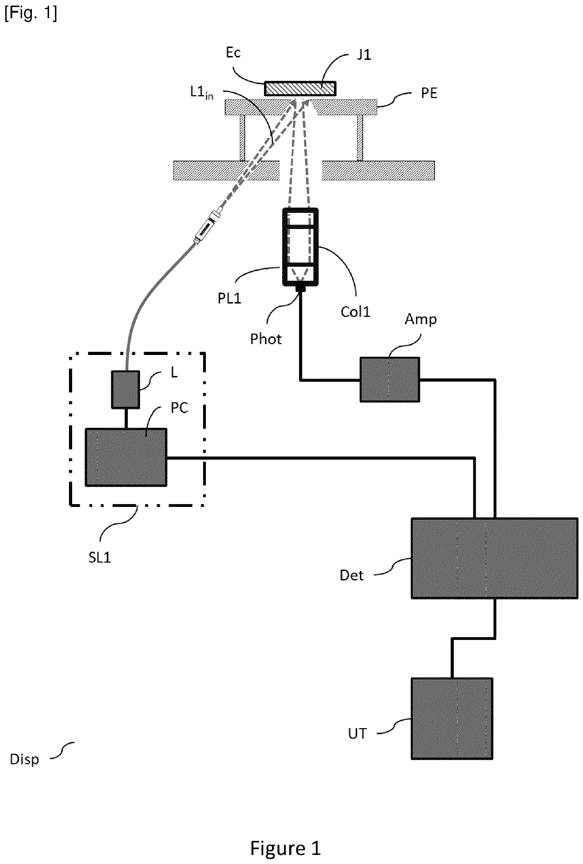

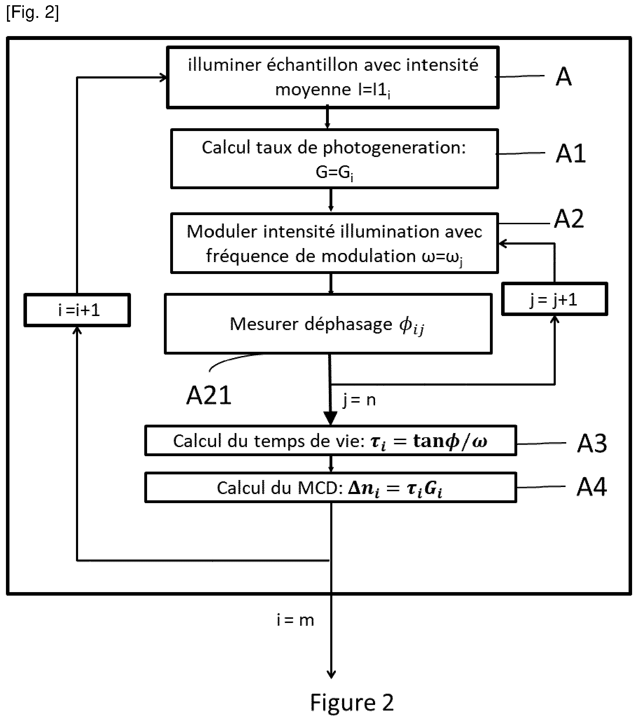

La figure 1 illustre une vue schématique d'un dispositif Disp selon l'invention pour mesurer in-situ le temps de vie des porteurs minoritaires dans un matériau semi-conducteur, pouvant par exemple être une cellule photovoltaïque Ec en mesurant un premier signal de photoluminescence PL1 . Ce dispositif est destiné à mettre en œuvre la méthode de la figure 2 que l'on détaillera plus loin.

Dans tous les modes de réalisation de l'invention, la cellule photovoltaïque Ec en matériau semiconducteur comporte au moins une première jonction J1 comportant une couche absorbant un rayonnement lumineux incident possédant une largeur de bande interdite ou « gap » $E_{g1}$. Par la suite on considère que les terme jonction et couche semi-conductrice absorbant un rayonnement incident sont équivalent. Ainsi, selon un mode de réalisation de l'invention, la cellule photovoltaïque est une cellule mono-jonction. Alternativement selon un autre mode de réalisation de l'invention la cellule photovoltaïque est une cellule comportant plusieurs jonctions comme une cellule multi-jonctions ou encore une cellule tandem (empilement de deux cellules).

Le dispositif Disp comprend une première source laser SL1 constituée d'une laser L et d'un modulateur PC. Le laser L est une source laser monochromatique de haute intensité. Ainsi, selon un mode de réalisation de l'invention le laser est une LED ou une SLED (Superluminescente diode en anglais). Alternativemet, selon un autre mode de réalisation de l'invention, le laser L comprend une source haute intensité et à large bande couplée à un filtre spectral. Selon un mode de réalisation de l'invention, le modulateur est un obturateur mécanique contrôlé electroniquement. Alternativement, selon un autre mode de réalisation, le modulateur est un modulateur électronique controlant l'alimentation du laser.

La première source laser est configurée pour émettre un premier rayonnement lumineux (ou signal d'excitation) $L1_{in}$ à une première longueur d'onde $\lambda_1$ , configurée pour émettre un rayonnement laser à une pluralité d'intensités moyennes distinctes $I1_i$ avec $i \in [1,m]$. De plus, par le biais du modulateur, la première source laser est configurée pour être modulée successivement à une pluralité de fréquences de modulation distinctes $\omega_j$ avec $j \in [1,n]$.

La première source laser est adaptée pour illuminer la première jonction J1 de la cellule photovoltaïque Ec de manière à générer un premier signal de photoluminescence PL1 dans la première jonction J1 de la cellule photovoltaïque. La première source laser SL1 est configurée pour émettre un rayonnement laser à une longueur d'onde $\lambda_1$ telle que $h/c\lambda_1 > E_{g1}$ afin d'exciter la cellule photovoltaïque.

Selon un mode de réalisation de l'invention, afin d'avoir un alignement plus robuste, au moins une partie du trajet optique du premier rayonnement lumineux $L1_{in}$ depuis la première source laser jusqu'à la cellule phoovoltaïque est fibré (comme représenté en figure 1). Le porte-échantillon PE est adapté pour maintenir la cellule photovoltaïque fixe pendant sa caractérisation au cours du procédé de fabrication afin d'effectuer des mesures in-situ. Par exemple, selon un mode de réalisation, le porte échantillon est placé au sein d'un réacteur lors de l'étape de recuit de la cellule photovoltaïque, afin de suivre l'évolution in-situ de la cellule photovoltaïque pendant cette étape.

Une fois excitée par le laser pulsé, la cellule solaire se trouve dans un état de déséquilibre. La cellule solaire revient à l'équilibre en émettant de la lumière (luminescence des cellules solaires et plus généralement des matériaux semiconducteurs). En particulier, le premier rayonnement lumineux excite les électrons dans la bande de valence du semiconducteur (e.g. silicium cristallin), ces derniers se trouvant à l'état excité dans la bande de conduction.

Ensuite, ces électrons se relaxent et se recombinent avec des trous (lacunes de charges positives) se trouvant dans la bande de valence. Cette relaxation est accompagnée par une émission de lumière où les photons possèdent une énergie égale au « gap » du semiconducteur (largeur de bande interdite). Ces recombinaisons radiatives sont à l'origine du signal de luminescence. En résumé, les photons du premier rayonnement lumineux illuminant la première jonction seront absorbés par cette dernière générant des paires d'électrons-trous et émettant des photons formant le premier signal de photoluminescence PL1.

Ainsi, la première source laser SL1 émet un premier rayonnement lumineux à une intensité moyenne $I1_i$ avec $i \in [1,m]$ modulé à une première fréquence de modulation $\omega_j$ avec $j \in [1,n]$ et générant un premier signal de photoluminescence associé que l'on nommera $PL1_{ij}$.

Le dispositif de la figure 1 comprend en outre un système optique de collection Col1 configuré pour collecter le premier signal de photoluminescence PL1. Selon un mode de réalisation de l'invention, ce dispositif optique est constitué d'un miroir parabolique et d'un ensemble de lentilles permettant de collimater le premier signal de photoluminescence et de le diriger sur une photodiode Phot permettant de détecter l'intensité du premier signal de photoluminescence. Selon un autre mode de réalisation de l'invention, ce dispositif optique est constitué d'un ensemble de doublet achromatique (doublet de lentilles) permettant de collimater le premier signal de photoluminescence. Selon un mode de réalisation, le premier signal de photoluminescence collecté est couplé à une fibre optique et dirigé sur la photodiode. Selon un autre mode de réalisation de l'invention, le premier signal de photoluminescence collecté est focalisé directement sur la photodiode.

La première source laser est configurée pour que le premier rayonnement lumineux illumine la première jonction avec une angle d'incidence suffisant pour que le système optique de collection ne collecte pas le premier rayonnement lumineux réfléchit par la cellule photovoltaïque. En plus, un filtre passe-haut est utilisé pour filtrer la réflexion de la première source laser. La première source laser est configurée pour que la surface illuminée (i.e. zone de photogénération ; typiquement d'un diamètre de quelques millimètres) soit plus grande le surface de collection (i.e. zone de mesure ; typiquement quelques dizaines à quelques centaines de microns).

Le dispositif comprend un pré-amplificateur Amp configuré pour amplifier le premier signal de photoluminescence après et détection par la photodiode Phot. Alternativement, selon un autre mode de réalisation le dispositif ne comprend pas d'amplificateur.

Après amplification, le premier signal de photoluminescence est dirigé vers un système de détection Det relié à la première source laser SL1 et à une unité de traitement UT. Selon une variante le système de détection comprend au moins un amplificateur à détection synchrone (Lock-In Amplifier en anglais).

La figure 2 illustre une méthode pour mesurer in-situ le temps de vie de porteurs minoritaires dans une cellule photovoltaïque selon l'invention, mise en œuvre par le dispositif de la figure 1.

Cette méthode comprend une première étape A consistant à illuminer, par à la première source laser SL1, au moins la première jonction J1 de la cellule photovoltaïque Ec avec un premier rayonnement lumineux $L1_{in}$ émis à une pluralité d'intensités moyennes $I1_i$, $i \in [1,m]$ et à une première longueur d'onde $\lambda_1$ adaptée pour générer un premier signal de photoluminescence PL1 dans ladite première jonction de la cellule photovoltaïque Ec.

Pour chaque $i \in [1,m]$ on réalise les sous-étapes A1-A4 suivantes :

Une étape A1 consiste à calculer, à l'aide de l'unité de traitement reliée au système de détection lui-même relié à la première source laser SL1, le taux de photogénération $G_i$ de porteurs de charge. On suppose que celui-ci est égal au flux de photons $F_i = I_i \lambda_1 / hc$ du premier rayonnement lumineux en supposant qu'un photon absorbé génère une paire électron-trou.

Une étape A2 consistant à moduler, grâce au modulateur PC, le premier rayonnement lumineux émis par la première source laser SL1 successivement à une pluralité n>1 de fréquences de modulation distinctes $\omega_j$ jE [1,n]. Les fréquences de modulation sont sélectionnée en fonction de la première source laser SL1, du préamplificateur et du lock-in amplifier. Typiquement, elles sont comprises entre 20 Hz et 100 kHz .

Pour chaque $j \in [1,n]$ on réalise la sous-étape A21 consistant à détecter l'amplitude, avec le système de détection Det, du premier signal de photoluminescence $PL1_{ij}$ associé au premier rayonnement lumineux d'intensité moyenne $I1_i$ et de fréquence de modulation $\omega_j$ et mesurer le déphasage $\phi_{ij}$ entre l'amplitude du premier rayonnement lumineux incident et l'amplitude du premier signal de photoluminescence PL1. La mesure du déphasage est par exemple réalisée par l'amplificateur à détection synchrone du système de détection, ledit amplificateur à détection synchrone étant synchronisé à la première source laser SL1.

La méthode de la figure 2 comprend une autre étape A3 consistant à calculer, grâce à l'unité de traitement Ut reliée au système de détection, le temps de vie

de porteurs minoritaires $\tau_i$ à partir des mesures du déphasage $\phi_{ij}$, avec $j \in [1,n]$ entre l'intensité du premier rayonnement lumineux incident et l'intensité du premier signal de photoluminescence. La relation entre le temps de vie de porteurs minoritaires $\tau_i$ pour une intensité moyenne $I1_i$, le déphasage $\phi_{ij}$ et la fréquence de modulation $\omega_j$ est donnée par l'équation suivante :

$$\tan(\phi_{ij}) = \tau_i \omega_j$$

Le temps de vie de porteurs minoritaires $\tau_i$ est donc calculé, par l'unité de traitement, à partir de la pente de la droite représentant la valeur de la tangente du déphasage $\tan(\phi_{ij})$ en fonction de la fréquence de modulation $\omega_j$, cette droite tracée pour toutes les fréquences de modulation $\omega_j$, $j \in [1,n]$. Il est nécessaire d'utiliser une pluralité de fréquences de modulation afin d'améliorer la fiabilité du calcul du temps de vie. Préférentiellement, au moins 3 fréquences de modulation sont utilisées.

La méthode de la figure 2 comprend une dernière étape A4, réalisée par l'unité de traitement, consistant à calculer la densité des porteurs minoritaires $\Delta n_i$ à partir du temps de vie des porteurs minoritaires $\tau_i$ et du taux de photogénération $G_i$ à partir de l'équation suivante :

$$\Delta n_i = \tau_i \times G_i$$

La méthode de la figure 2 permet de calculer une densité $\Delta n_i$ et un temps de vie $\tau_i$ de porteurs de charge minoritaires pour chaque intensité moyenne $I1_i$, $i \in [1,m]$ du premier rayonnement lumineux. Il est intéressant de calculer le temps de vie des porteurs minoritaires pour une pluralité d'intensités moyennes distinctes car, comme nous l'expliquerons plus loin, cela constitue une étape nécessaire pour la détermination du temps de vie pour une densité de porteurs spécifique de référence. Or, cette détermination est critique car le temps de vie varie fortement en fonction de la densité de porteurs minoritaires (variation pouvant aller de 100 à 1000 $\mu$s voir plus pour le silicium cristallin). C'est la raison pour laquelle, dans la communauté photovoltaïque ou électronique, le temps de vie des porteurs minoritaires est présenté pour une densité de porteurs spécifique (e.g. $10^{15}$ cm$^{-3}$ pour une cellule solaire mono-jonction en silicium cristallin). Cela permet de comparer les propriétés des cellules solaires bien qu'elles sont fabriquées par des méthodes différentes ou dans différents laboratoires. Cependant, l'intensité laser est reliée au taux de photogénération et fait par ailleurs varier la densité de porteurs. C'est pourquoi il est très dificile de mesurer le temps de vie des porteurs à une densité des porteurs souhaitée. Il est donc nécessaire de mesurer le temps de vie des porteurs pour plusieurs intensités laser afin de calculer le temps de vie $\tau$ à une densité $\Delta n$ souhaitée (e.g. $10^{15}$

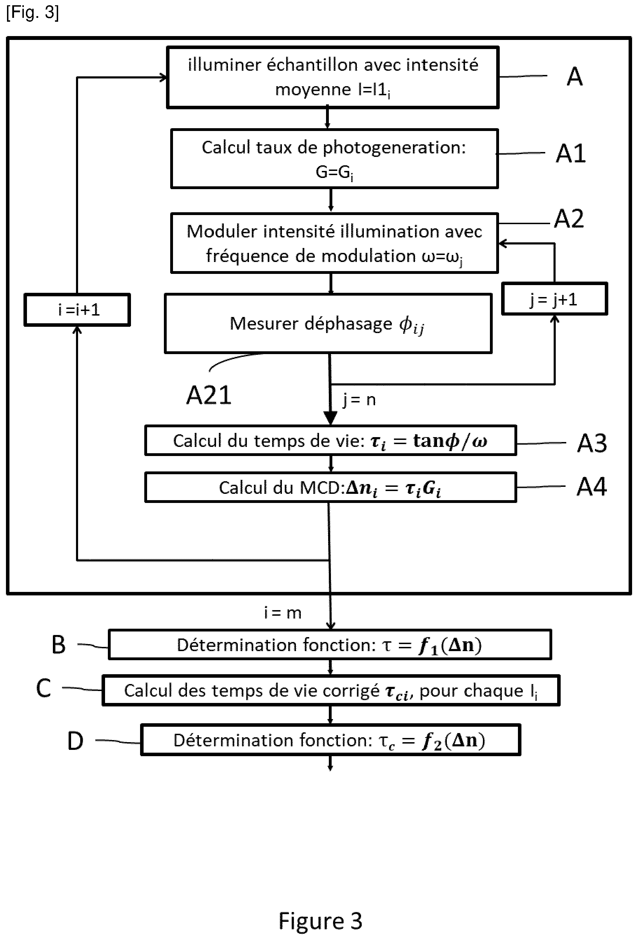

cm$^{-3}$) par interpolation ou extrapolation à l'aide de la méthode de la figure 3 détaillée plus loin.

De plus, la méthode de la figure 2 peut être réalisée in-situ par le dispositif de la figure 1 en répétant la totalité des étapes A-A4 plusieurs fois pendant un procédé de traitement de la cellule photovoltaïque afin d'observer commment le temps de vie de porteurs minoritaires évolue au cours du procédé.

Pour fonctionner, la méthode illustrée dans la figure 2 nécessite un temps de vie des porteurs de charge minoritaires suffisament long. Ainsi, la première jonction J1 est réalisée dans un matériau tel que le temps de vie de porteurs de charge minoritaires soit supérieure à 1 $\mu$s, préferentiellement supérieur à 10 $\mu$s. Ainsi, selon un mode de réalisation la première jonction J1 est réalisée en silicium cristallin (de gap $E_{g1}$) et la première source laser est configurée pour émettre un premier rayonnement à une première longueur d'onde $\lambda_1 < hc/E_g$. Ainsi dans un exemple donné à titre non limitatif la première source laser est configurée pour émettre à une longueur d'onde $\lambda_1$=785 nm.

La figure 3 illustre une méthode pour mesurer in-situ le temps de vie de porteurs minoritaires dans une cellule photovoltaïque selon une variante de l'invention, mise en œuvre par le dispositif de la figure 1. Cette méthode est identique à celle illustrée dans la figure 2 à l'exception qu'elle comporte trois étapes B, C et D réalisées successivement après les étapes A-A4 réalisées pour une pluralité d'intensités moyennes I1$_i$, i∈[1,m] du premier rayonnement lumineux.

L'étape B consiste en la détermination par l'unité de traitement d'une première fonction continue f$_1$ calculant le temps de vie de porteurs minoritaires en fonction de la densité de porteurs minoritaires à partir des valeurs du temps de vie et de la densité de porteurs minoritaires déterminées lors de l'étape A4. Cette étape permet donc la détermination d'une fonction calculant le temps de vie de porteurs minoritaires pour une densité de porteurs spécifique de référence. De plus, cette fontion continue nous permet d'avoir les bons paramètres utilisés pour la correction du calcul de temps de vie effectuée dans l'étape C.

L'étape C, effectuée après l'étape B, consiste à calculer, avec l'unité de traitement, le temps de vie de porteurs minoritaires corrigé à partir de la dérivée de la fonction f$_1$, du calcul du temps de vie de porteurs minoritaires et du taux de photogénération. En effet, le calcul du temps de vie de porteurs minoritaires effectué lors de l'étape A3 est un temps de vie dit différentiel car la technique de mesure du déphasage est elle-même est une technique de mesure dynamique des propriétés de recombinaison des porteurs de charges basée sur une variation relative de l'éclairement. C'est-à-dire que l'on détermine un paramètre global de la cellule photovoltaïque (le temps de vie des porteurs de charge $\tau_i$ pour une intensitée moyenne I1$_i$) en comparant des mesures où seul la fréquence de modulation $\omega_j$ de l'éclairement de la cellule varie. Le calcul du temps de vie des porteurs

minoritaires corrigé $\tau_{ci}$, effectué pour chaque d'intensité moyenne I1$_i$, i∈[1,m] du premier rayonnement lumineux, est donné par l'équation suivante :

$$\tau_{ci} = \tau_i \left( 1 - G_i \frac{d\tau}{d\Delta n} \big|_{\Delta n_i} \right)$$

Avec $\frac{d\tau}{d\Delta n}\big|_{\Delta n_i}$ la dérivée de la fonction f$_1$ pour la densité de porteurs $\Delta n_i$ calculé pour l'intensité I1$_i$.

Enfin la méthode selon une première variante de l'invention comprend une étape D, après l'étape C, de détermination par l'unité de traitement d'une deuxième fonction continue f$_2$ calculant le temps de vie de porteurs minoritaires corrigée en fonction de la densité de porteurs minoritaires à partir des valeurs du temps de vie de porteurs minoritaires corrigé $\tau_{ci}$ déterminées lors de l'étape C.

L'étape D permet la détermination d'une fonction calculant le temps de vie des porteurs minoritaires corrigée pour une densité de porteurs spécifique. Le temps de vie calculé par la fonction f$_2$ est le temps de vie corrigé, à l'inverse du temps de vie calculé par la fonction f$_1$ qui permet de calculer le temps de vie différentiel. Le temps de vie corrigé est un temps de vie standard utilisé dans la comunauté photovoltaïque et micro-électronique pour caractériser les propriétés d'un matériaux semi-conducteur. Selon un mode de réalisation de cette première variante de l'invention, seule l'étape B est réalisée, les étapes C et D étant omises.

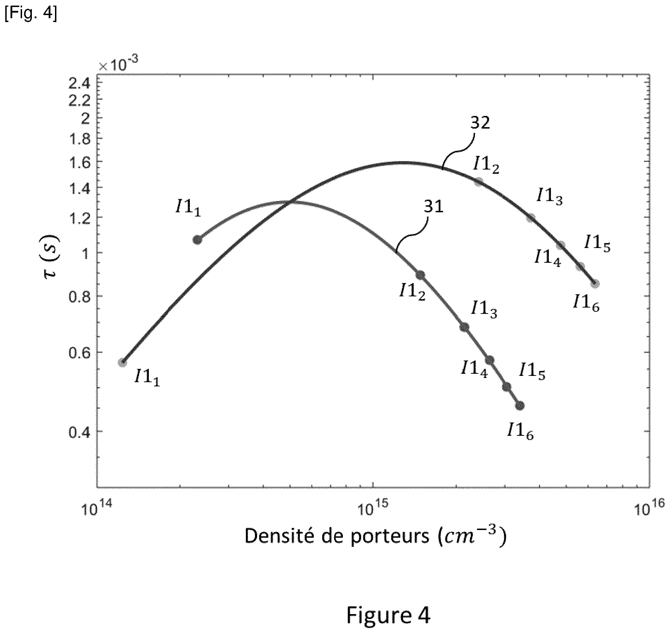

La figure 4 est un graphique représentant la première fonction f$_1$ (courbe 31), déterminée lors de l'étape B de la méthode de la première variante de l'invention, calculant l'évolution du temps de vie de porteurs minoritaires en fonction de la densité de porteurs minoritaires. La figure 4 représente de plus la deuxième fonction f$_2$ (courbe 32), déterminée lors de l'étape D de la méthode de la première variante de l'invention, calculant l'évolution du temps de vie de porteurs minoritaires corrigée en fonction de la densité de porteurs minoritaires.

La courbe 32 permet donc de déterminer le temps de vie de porteurs de charges minoritaires corrigé pour une densité de porteurs spécifique.

Dans l'exemple de la figure 4 le nombre d'intensités moyennes distinctes I1$_i$ du premier rayonnement lumineux est 6. Cet exemple est donné à titre non limitatif et selon un mode de réalisation de la première variation l'invention, un nombre différent de 6 intensités moyennes distinctes est utilisé lors de la réalisation de la la méthode illustré en figure 3 par le dispositif Disp de la figure 1. Dans cet exemple les intensités lasers vont de 2 mW à 50 mW et les fréquences de modulations sont comprises entre 225 Hz et 1025 Hz.

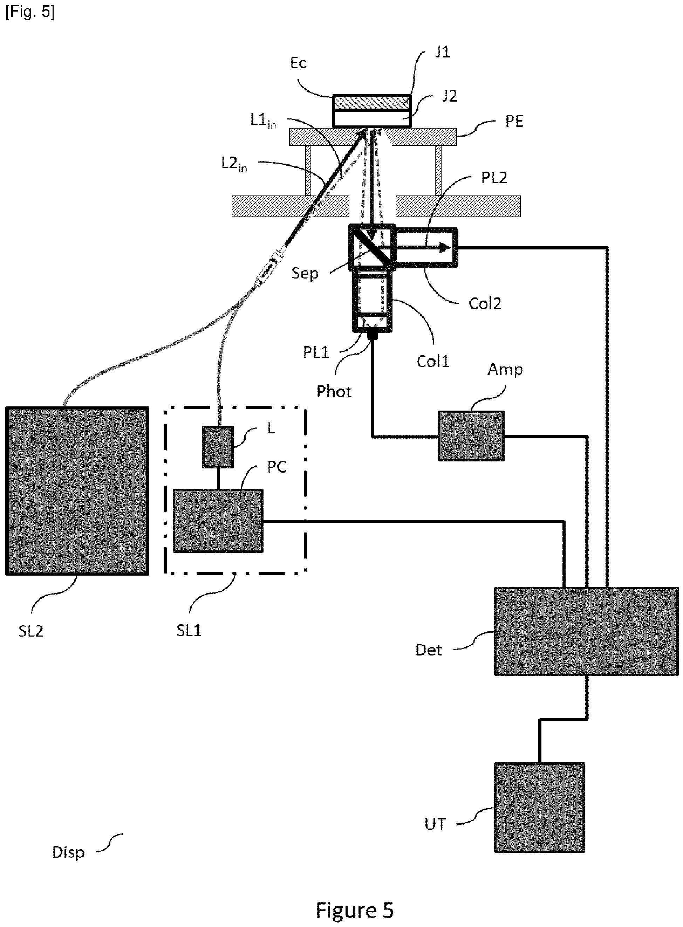

La figure 5 illustre une vue schématique d'un dispositif Disp selon un mode de réalisation de l'invention pour mesurer in-situ le temps de vie de porteurs minoritaires dans une cellule photovoltaïque Ec. Dans ce mode de réalisation, la cellule photovoltaïque comprend au moins deux jonctions, une première jonction J1 de gap $E_{g1}$ et une deuxième jonction J2 de gap $E_{g2} > E_{g1}$. La deuxième jonction de la cellule photovoltaïque peut être réalisée dans un matériau semi-conducteur du groupe III-V, en perovskite ou encore en CIGS. Ainsi, dans ce mode de réalisation, la cellulle photovoltaïque est une cellule comportant au moins deux jonctions comme une cellule multi-jonctions ou encore une cellule tandem (empilement de deux cellules).

Le dispositif du mode de réalisation de la figure 5 est identique à celui de la figure 1 à l'exception qu'il comprend une deuxième source laser SL2 émettant un deuxième rayonnement lumineux L2in à une deuxième longueur d'onde $\lambda_2$ à intensité constante. La deuxième source laser est configurée pour illuminer la deuxième jonction J2 de la cellule photovoltaïque et pour générer un deuxième signal de photoluminescence PL2 dans ladite deuxième jonction de la cellule photovoltaïque. La deuxième source laser SL2 est une source laser monochromatique de haute intensité. Ainsi, selon un mode de réalisation la deuxième source laser est une LED ou une SLED.

Dans le mode de réalisation de la figure 5, la première source et la deuxième source laser sont configurées de manière à ce que la deuxième longueur d'onde soit inférieure à la première longueur d'onde ($\lambda_2 < \lambda_1$) et de manière à ce que le deuxième rayonnement lumineux soit totalement absorbé par la deuxième jonction de la cellule photovoltaïque alors que le premier rayonnement lumineux traverse la deuxième jonction pour être absorbé par la première jonction.

Le dispositif de la figure 5 comprend en outre un composant optique séparateur Sep adapté pour séparer spatialement le premier signal de photoluminescence et le deuxième signal de photoluminescence issus de la cellule photovoltaïque. Selon un mode de réalisation, le composant optique séparateur est un miroir dichroïque.

Dans le mode de réalisation de la figure 5, le système de détection comprend en plus un photodétecteur configuré pour détecter et mesurer l'intensité du deuxième signal de photoluminescence. Selon un mode de réalisation le photodétecteur du système de détection est une photodiode ou une photodiode à avalanche.

Le dispositif de la figure 5 est destiné à mettre en œuvre la même méthode que celle de la figure 2 à l'exception que l'étape A comprend en outre l'illumination de la deuxième jonction J2 de la cellule photovoltaïque avec le deuxième rayonnement lumineux L2in à une deuxième longueur d'onde adaptée pour générer un deuxième signal de photoluminescence PL2 dans ladite deuxième jonction de la cellule photovoltaïque et l'étape A21 comprend en outre la détection du deuxième signal de photoluminescence et la mesure de l'intensité du deuxième signal de photoluminescence.

La mesure de l'intensité du deuxième signal de photoluminescence permet de remonter aux propriétés électriques de la deuxième jonction de la cellule photovoltaïque. De plus, cette mesure est réalisée simultanément à la mesure du déphasage entre l'amplitude du premier rayonnement lumineux incident et l'amplitude du premier signal de photoluminescence PL1. Ainsi, il est possible de caractériser simultanément et indépendamment la première jonction et la deuxième jonction de la cellule photovoltaïque.

## Revendications

1. Méthode pour mesurer in situ le temps de vie de porteurs minoritaires dans un matériau semi-conducteur (Ec) comprenant au moins une première jonction (J1) en mesurant un premier signal de photoluminescence (PL1), ladite méthode comprenant :

    A. illuminer au moins la première jonction (J1) du matériau semi-conducteur (Ec) avec un premier rayonnement lumineux (L1$_{in}$) émis à une pluralité d'intensités moyennes I1$_i$, i$\in$[1,m] et à une première longueur d'onde adaptée pour générer un premier signal de photoluminescence (PL1) dans ladite première jonction du matériau semi-conducteur ;
    pour chaque i$\in$[1,m] on réalise les sous-étapes consistant à :

        A1- calculer le taux de photogénération $G_i$ de porteurs de charge ;
        A2-moduler ledit premier rayonnement lumineux successivement à une pluralité n>1 de fréquences de modulation distinctes $\omega_j$ j$\in$[1,n]
        et pour chaque j$\in$[1,n] :
        A21-détecter le premier signal de photoluminescence (PL1) et mesurer le déphasage $\phi_{ij}$ entre une amplitude du premier rayonnement lumineux incident (L1$_{in}$) et une amplitude du premier signal de photoluminescence (PL1)
        A3-calculer le temps de vie de porteurs minoritaires $\tau_i$ à partir des mesures dudit déphasage $\phi_{ij}$, avec j$\in$[1,n],;
        A4-calculer la densité de porteurs minoritaires $\Delta n_i$ à partir du temps de vie des porteurs minoritaires $\tau_i$ et du taux de photogénération $G_i$

    B. déterminer une fonction continue, dite première fonction, représentative de l'évolution du temps de vie de porteurs minoritaires en fonction de la densité de porteurs minoritaires à partir des valeurs déterminées lors de l'étape A4,
    C. calculer une valeur du temps de vie de porteurs minoritaires corrigé pour ladite pluralité d'intensités moyennes, ledit calcul étant effectué à partir de la dérivée de la première fonction, du calcul du temps de vie de porteurs minoritaires et du taux de photogénération,

D. déterminer une fonction continue, dite deuxième fonction, calculant le temps de vie de porteurs minoritaires corrigé en fonction de la densité de porteurs minoritaires, à partir des valeurs du temps de vie de porteurs minoritaires corrigé déterminées dans l'étape C.

2. Méthode selon la revendication précédente, dans laquelle le matériau semi-conducteur comprend en outre une deuxième jonction (J2) de largeur de bande interdite supérieure à la largeur de la bande interdite de la première jonction et dans laquelle:

   - l'étape A comprend en outre l'illumination de la deuxième jonction, avec un deuxième rayonnement lumineux ($L2_{in}$) à une deuxième longueur d'onde adaptée pour générer un deuxième signal de photoluminescence (PL2) dans ladite deuxième jonction du matériau semi-conducteur;
   - l'étape A21 comprend en outre la détection, ledit deuxième signal de photoluminescence et la mesure de l'intensité du deuxième signal de photoluminescence.

3. 4 Méthode selon la revendication précédente dans laquelle, lors de l'illumination, la deuxième longueur d'onde est inférieure à la première longueur d'onde et le deuxième rayonnement lumineux est absorbé par la deuxième jonction du matériau semi-conducteur alors que le premier rayonnement lumineux traverse la deuxième jonction pour être absorbé par la première jonction.

4. Méthode selon l'une quelconques des revendications précédentes, dans laquelle au moins les étapes A à A4 sont répétées plusieurs fois pendant un procédé de traitement du matériau semi-conducteur.

5. Dispositif (Disp) pour mesurer in situ le temps de vie de porteurs minoritaires dans un matériau semi-conducteur (Ec) comprenant au moins une première jonction (J1) en mesurant un premier signal de photoluminescence (PL1), ledit dispositif comprenant :

   - au moins une première source laser (SL1) émettant un premier rayonnement lumineux ($L1_{in}$) à une première longueur d'onde, configurée pour émettre un rayonnement laser à une pluralité d'intensités moyennes distinctes $I1_i$ avec $i \in [1,m]$ et configurée pour être modulé successivement à une pluralité de fréquences de modulation distinctes $\omega_j$ avec $j \in [1,n]$ et configurée pour illuminer une première jonction du matériau semi-conducteur de manière à générer un premier signal de photoluminescence (PL1) dans ladite première jonction (J1) du matériau semi-conducteur;

   - un système de détection (Det) relié à ladite première source laser (SL1), adapté pour détecter le premier signal de photoluminescence (PL1) et mesurer des déphasages $\phi_{ij}$, entre l'amplitude de chaque premier rayonnement lumineux incident ($L1_{in}$) d'intensité $I1_i$ et de fréquence de modulation $\omega_j$ et l'ampltiude du premier signal de photoluminescence (PL1) associé;
   - une unité de traitement (UT) reliée au système de détection adaptée pour :

       - calculer, pour chaque intensité moyenne distincte $I1_i$ du premier rayonnement lumineux, le taux de photogénération $G_i$ de porteurs de charge minoritaires;
       - calculer, pour chaque intensité moyenne $I1_i$ distincte du premier rayonnement lumineux , le temps de vies de porteurs minoritaires $\tau_i$ à partir des mesures du déphasage $\phi_{ij}$;
       - calculer, pour chaque intensité moyenne $I1_i$ distincte du premier rayonnement lumineux , la densité de porteur minoritaires $\Delta n_i$ à partir du temps de vie des porteurs minoritaires $\tau_i$ et du taux de photogénération $G_i$,
       - ajuster une fonction continue, dite première fonction, calculant le temps de vie des porteurs minoritaires en fonction de la densité de porteurs minoritaires pour la pluralité d'intensités moyennes distinctes du premier rayonnement lumineux
       - calculer des valeurs du temps de vie de porteurs minoritaires corrigé, ledit calcul étant effectué à partir de la dérivée de la première fonction, du calcul du temps de vie de porteurs minoritaires et du taux de photogénération,
       - déterminer une fonction continue, dite deuxième fonction, calculant le temps de vie de porteurs minoritaires corrigé en fonction de la densité de porteurs minoritaires à partir des valeurs du temps de vie de porteurs minoritaires corrigé calculées.

6. Dispositf selon la revendication 5, dans lequel le système de détection comprend au moins un amplificateur à détection synchrone.

7. Dispositif selon l'une quelconque des deux revendications précédentes comprenant :

   - une deuxième source laser (SL2) émettant un deuxième rayonnement lumineux ($L2_{in}$) à une

deuxième longueur d'onde, ladite deuxième source laser étant configurée pour illuminer une deuxième jonction (J2) du matériau semi-conducteur, de largeur de bande interdite supérieure à la largeur de la bande interdite de la première jonction et pour générer un deuxième signal de photoluminescence (PL2) dans ladite deuxième jonction du matériau semi-conducteur,

- un composant optique séparateur (Sep) adapté pour séparer spatialement le premier signal de photoluminescence et le deuxième signal de photoluminescence ; ledit système de détection étant en outre configuré pour détecter ledit deuxième signal de photoluminescence et mesurer l'intensité du deuxième signal de photoluminescence.

**8.** Dispositif selon la revendication précédente, dans lequel la première source et la deuxième source laser sont configurées de manière à ce que la deuxième longueur d'onde soit inférieure à la première longueur d'onde et le deuxième rayonnement lumineux soit absorbé par la deuxième jonction du matériau semi-conducteur alors que le premier rayonnement lumineux traverse la deuxième jonction pour être absorbé par la première jonction.

**9.** Dispositf selon l'une quelconques des deux revendications précédentes, dans lequel le système de détection comprend au moins un photodétecteur.

**Patentansprüche**

**1.** Verfahren zum In-situ-Messen der Lebensdauer von Minoritätsträgern in einem Halbleitermaterial (Ec), das mindestens einen ersten Übergang (J1) umfasst, durch Messen eines ersten Photolumineszenzsignals (PL1), wobei das Verfahren Folgendes umfasst:

A. Beleuchten mindestens des ersten Übergangs (J1) des Halbleitermaterials (Ec) mit einer ersten Lichtstrahlung (L1$_{in}$), die mit einer Vielzahl von durchschnittlichen Intensitäten I1$_i$, $i \in [1,m]$, und bei einer ersten Wellenlänge emittiert wird, die dazu ausgelegt ist, ein erstes Photolumineszenzsignal (PL1) in dem ersten Übergang des Halbleitermaterials zu erzeugen; für jedes $i \in [1,m]$ werden die Teilschritte ausgeführt, bestehend aus:

A1 - Berechnen der Photogenerationsrate G$_i$ der Ladungsträger;
A2 - Modulieren der ersten Lichtstrahlung nacheinander mit einer Vielzahl $n>1$ unterschiedlicher Modulationsfrequenzen $\omega_j$,

$j \in [1,n]$, und für jedes $j \in [1,n]$:

A21 - Erkennen des ersten Photolumineszenzsignals (PL1) und Messen der Phasenverschiebung $\Phi_{ij}$ zwischen einer Amplitude der ersten einfallenden Lichtstrahlung (L1$_{in}$) und einer Amplitude des ersten Photolumineszenzsignals (PL1)
A3 - Berechnen der Lebensdauer der Minoritätsträger T$_i$ aus Messungen der Phasenverschiebung $\Phi_{ij}$, mit je[1,n];
A4 - Berechnen der Minoritätsträgerdichte $\Delta n_i$ aus der Lebensdauer der Minoritätsträger T$_i$ und der Photogenerationsrate G$_i$

B. Bestimmen, aus den in Schritt A4 bestimmten Werten, einer kontinuierlichen Funktion, die als erste Funktion bezeichnet wird, die die Entwicklung der Lebensdauer von Minoritätsträgern in Abhängigkeit von der Dichte der Minoritätsträger darstellt,
C. Berechnen eines Werts der Lebensdauer der Minoritätsträger, korrigiert um die Vielzahl von durchschnittlichen Intensitäten, wobei die Berechnung aus der Ableitung der ersten Funktion, der Berechnung der Lebensdauer der Minoritätsträger und der Photogenerationsrate durchgeführt wird,
D. Bestimmen, aus den in Schritt C bestimmten Werten der korrigierten Lebensdauer der Minoritätsträger, einer kontinuierlichen Funktion, die als zweite Funktion bezeichnet wird, durch Berechnen der korrigierten Lebensdauer der Minoritätsträger in Abhängigkeit von der Dichte der Minoritätsträger.

**2.** Verfahren nach dem vorstehenden Anspruch, wobei das Halbleitermaterial ferner einen zweiten Übergang (J2) mit einer Bandlückenbreite umfasst, die größer als die Breite der Bandlücke des ersten Übergangs ist, und wobei:

- Schritt A ferner das Beleuchten des zweiten Übergangs mit einer zweiten Lichtstrahlung (L2$_{in}$) bei einer zweiten Wellenlänge umfasst, die dazu ausgelegt ist, ein zweites Photolumineszenzsignal (PL2) in dem zweiten Übergang des Halbleitermaterials zu erzeugen;
- Schritt A21 ferner das Erkennen des zweiten Photolumineszenzsignals und das Messen der Intensität des zweiten Photolumineszenzsignals umfasst.

**3.** Verfahren nach dem vorstehenden Anspruch, wobei während der Beleuchtung die zweite Wellenlänge kleiner als die erste Wellenlänge ist und die zweite Lichtstrahlung vom zweiten Übergang des Halbleitermaterials absorbiert wird, während die erste Lichtstrahlung den zweiten Übergang durchquert, um vom ersten Übergang absorbiert zu werden.

4. Verfahren nach einem der vorstehenden Ansprüche, wobei mindestens die Schritte A bis A4 während eines Verarbeitungsprozesses des Halbleitermaterials mehrmals wiederholt werden.

5. Vorrichtung (Disp) zum In-situ-Messen der Lebensdauer von Minoritätsträgern in einem Halbleitermaterial (Ec), das mindestens einen ersten Übergang (J1) umfasst, durch Messung eines ersten Photolumineszenzsignals (PL1), wobei die Vorrichtung Folgendes umfasst:

   - mindestens eine erste Laserquelle (SL1), die eine erste Lichtstrahlung (L1$_{in}$) mit einer ersten Wellenlänge emittiert, die konfiguriert ist, um Laserstrahlung mit einer Vielzahl von unterschiedlichen durchschnittlichen Intensitäten I1$_i$ mit i∈[1,m] zu emittieren und konfiguriert ist, um nacheinander mit einer Vielzahl von unterschiedlichen Modulationsfrequenzen ω$_j$ mit j∈[1,n] moduliert zu werden und konfiguriert ist, um einen ersten Übergang des Halbleitermaterials zu beleuchten, um so ein erstes Photolumineszenzsignal (PL1) in dem ersten Übergang (J1) des Halbleitermaterials zu erzeugen;
   - ein Detektionssystem (Det), das mit der ersten Laserquelle (SL1) verbunden ist und dazu ausgelegt ist, das erste Photolumineszenzsignal (PL1) zu erkennen und Phasenverschiebungen Φ$_{ij}$, zwischen der Amplitude jeder ersten einfallenden Lichtstrahlung (L1$_{in}$) der Intensität I1$_i$ und der Modulationsfrequenz ω$_j$ und der Amplitude des zugehörigen ersten Photolumineszenzsignals (PL1) zu messen;
   - eine Verarbeitungseinheit (UT), die mit dem Detektionssystem verbunden ist und für Folgendes ausgelegt ist:

      - Berechnen, für jede unterschiedliche durchschnittliche Intensität I1$_i$ der ersten Lichtstrahlung, der Photogenerationsrate G$_i$ der Minoritätsladungsträger;
      - Berechnen, für jede unterschiedliche durchschnittliche Intensität I1$_i$ der ersten Lichtstrahlung, der Lebensdauer der Minoritätsträger T$_i$ aus Messungen der Phasenverschiebung Φ$_{ij}$;
      - Berechnen, für jede unterschiedliche durchschnittliche Intensität I1$_i$ der ersten Lichtstrahlung, der Dichte der Minoritätsträger Δn$_i$ aus der Lebensdauer der Minoritätsträger T$_i$ und der Photogenerationsrate G$_i$,
      - Anpassen einer kontinuierlichen Funktion, die als erste Funktion bezeichnet wird, durch Berechnen der Lebensdauer der Minoritätsträger in Abhängigkeit von der Dichte der Minoritätsträger für die Vielzahl unterschiedlicher durchschnittlicher Intensitäten der ersten Lichtstrahlung
      - Berechnen der Werte der korrigierten Lebensdauer der Minoritätsträger, wobei die Berechnung aus der Ableitung der ersten Funktion, der Berechnung der Lebensdauer der Minoritätsträger und der Photogenerationsrate durchgeführt wird,
      - Bestimmen, aus den berechneten Werten der korrigierten Lebensdauer der Minoritätsträger, einer kontinuierlichen Funktion, die als zweite Funktion bezeichnet wird, durch Berechnen der korrigierten Lebensdauer der Minoritätsträger in Abhängigkeit von der Dichte der Minoritätsträger.

6. Vorrichtung nach Anspruch 5, wobei das Detektionssystem mindestens einen synchronen Detektionsverstärker umfasst.

7. Vorrichtung nach einem der zwei vorstehenden Ansprüche, umfassend:

   - eine zweite Laserquelle (SL2), die eine zweite Lichtstrahlung (L2$_{in}$) bei einer zweiten Wellenlänge emittiert, wobei die zweite Laserquelle konfiguriert ist, um einen zweiten Übergang (J2) des Halbleitermaterials mit einer Bandlückenbreite zu beleuchten, die größer als die Breite der Bandlücke des ersten Übergangs ist, und um ein zweites Photolumineszenzsignal (PL2) in dem zweiten Übergang des Halbleitermaterials zu erzeugen,
   - eine optische Trennkomponente (Sep), die dazu ausgelegt ist, das erste Photolumineszenzsignal und das zweite Photolumineszenzsignal räumlich zu trennen; wobei das Detektionssystem ferner konfiguriert ist, um das zweite Photolumineszenzsignal zu erkennen und die Intensität des zweiten Photolumineszenzsignals zu messen.

8. Vorrichtung nach dem vorstehenden Anspruch, wobei die erste Laserquelle und die zweite Laserquelle so konfiguriert sind, dass die zweite Wellenlänge kleiner als die erste Wellenlänge ist und die zweite Lichtstrahlung von dem zweiten Übergang des Halbleitermaterials absorbiert wird, während die erste Lichtstrahlung den zweiten Übergang durchquert, um vom ersten Übergang absorbiert zu werden.

9. Vorrichtung nach einem der zwei vorstehenden Ansprüche, wobei das Detektionssystem mindestens einen Photodetektor umfasst.

## Claims

1. A method for in situ measuring the minority carrier lifetime in a semiconductor material (Ec) comprising at least a first junction (J1) by measuring a first photoluminescence signal (PL1), said method comprising:

    A. illuminating at least the first junction (J1) of the semiconductor material (Ec) with a first light radiation ($L1_{in}$) emitted at a plurality of average intensities $I1_i$, $i \in [1,m]$ and at a first wavelength adapted to generate a first photoluminescence signal (PL1) in said first junction of the semiconductor material;
    for each $i \in [1,m]$ we perform the sub-steps consisting of:

        A1- calculating the photogeneration rate $G_i$ of charge carriers;
        A2-modulating said first light radiation successively at a plurality n>1 of distinct modulation frequencies $\omega_j$ $j \in [1,n]$ and for each $j \in [1,n]$:

            A21-detecting the first photoluminescence signal (PL1) and measuring the phase shift $\Phi_{ij}$ between an amplitude of the first incident light radiation ($L1_{in}$) and an amplitude of the first photoluminescence signal (PL1)
            A3-calculating the minority carrier lifetime $T_i$ from measurements of said phase shift $\Phi_{ij}$, with $j \in [1,n]$;
            A4-calculating the minority carrier density $\Delta n_i$ from the minority carrier lifetime $T_i$ and the photogeneration rate $G_i$,

    B. determining a continuous function, called the first function, representative of the evolution of the minority carrier lifetime as a function of the minority carrier density from the values determined in step A4,
    C. calculating a corrected minority carrier lifetime value for said plurality of average intensities, said calculation being performed from the derivative of the first function, the calculation of the minority carrier lifetime and the photogeneration rate,
    D. determining a continuous function, the so-called second function, calculating the corrected minority carrier lifetime as a function of the minority carrier density, from the corrected minority carrier lifetime values determined in step C.

2. The method according to the preceding claim, wherein the semiconductor material further comprises a second junction (J2) of bandgap width greater than the bandgap width of the first junction, and wherein:

    - step A further comprises illuminating the second junction, with second light radiation ($L2_{in}$) at a second wavelength adapted to generate a second photoluminescence signal (PL2) in said second junction of the semiconductor material;
    - step A21 further comprises detecting said second photoluminescence signal and measuring the intensity of the second photoluminescence signal.

3. The method according to the preceding claim, wherein, during illumination, the second wavelength is shorter than the first wavelength and the second light radiation is absorbed by the second junction of the semiconductor material, while the first light radiation passes through the second junction to be absorbed by the first junction.

4. The method according to any one of the preceding claims, wherein at least steps A to A4 are repeated several times during a process of treating the semiconductor material.

5. A device (Disp) for in situ measuring the minority carrier lifetime in a semiconductor material (Ec) comprising at least a first junction (J1), by measuring a first photoluminescence signal (PL1), said device comprising:

    - at least one first laser source (SL1) emitting a first light radiation ($L1_{in}$) at a first wavelength, configured to emit laser radiation at a plurality of distinct average intensities $I1_i$ with $i \in [1,m]$ and configured to be successively modulated at a plurality of distinct modulation frequencies $\omega_j$ with $j \in [1,n]$ and configured to illuminate a first junction of the semiconductor material so as to generate a first photoluminescence signal (PL1) in said first junction (J1) of the semiconductor material;
    - a detection system (Det) connected to said first laser source (SL1), adapted to detect the first photoluminescence signal (PL1) and to measure phase shifts $\Phi_{ij}$, between the amplitude of each first incident light beam ($L1_{in}$) of intensity $I1_i$ and modulation frequency $\omega_j$ and the amplitude of the associated first photoluminescence signal (PL1);
    - a processing unit (UT) connected to the detection system suitable for:

        - calculating, for each distinct average intensity $I1_i$ of the first light beam, the rate of photogeneration $G_i$ of minority charge carriers;

- calculating, for each distinct average intensity $I1_i$ of the first light beam, the minority carrier lifetime $T_i$ from phase shift measurements $\Phi_{ij}$;
- calculating, for each distinct average intensity $I1_i$ of the first light beam, the minority carrier density $\Delta n_i$ from the minority carrier lifetime $T_i$ and the photogeneration rate $G_i$,
- adjusting a continuous function, called the first function, calculating the minority carrier lifetime as a function of the minority carrier density for the plurality of distinct average intensities of the first light radiation
- calculating values for the corrected minority carrier lifetime, said calculation being based on the derivative of the first function, the calculation of the minority carrier lifetime and the photogeneration rate,
- determining a continuous function, the so-called second function, calculating the corrected minority carrier lifetime as a function of the minority carrier density from the calculated corrected minority carrier lifetime values.

6. The device according to claim 5, wherein the detection system comprises at least one synchronous detection amplifier.

7. The method according to either one of the two preceding claims, comprising:

   - a second laser source (SL2) emitting a second light beam ($L2_{in}$) at a second wavelength, said second laser source being configured to illuminate a second junction (J2) of semiconductor material, with a bandgap greater than the bandgap of the first junction, and to generate a second photoluminescence signal (PL2) in said second junction of semiconductor material,
   - a beamsplitter (Sep) adapted to spatially separate the first photoluminescence signal and the second photoluminescence signal; said detection system being further configured to detect said second photoluminescence signal and to measure the intensity of the second photoluminescence signal.

8. The device according to the preceding claim, wherein the first and second laser sources are configured so that the second wavelength is shorter than the first wavelength and the second light radiation is absorbed by the second junction of the semiconductor material, while the first light radiation passes through the second junction to be absorbed by the first junction.

9. The device according to either one of the two preceding claims, wherein the detection system comprises at least one photodetector.

[Fig. 1]

Figure 1

[Fig. 2]

Figure 2

[Fig. 3]

illuminer échantillon avec intensité moyenne I=I1$_i$ — **A**

Calcul taux de photogeneration: G=G$_i$ — **A1**

Moduler intensité illumination avec fréquence de modulation ω=ω$_j$ — **A2**

i =i+1

Mesurer déphasage $\phi_{ij}$

j = j+1

**A21**

j = n

Calcul du temps de vie: $\tau_i = \tan\phi/\omega$ — **A3**

Calcul du MCD: $\Delta n_i = \tau_i G_i$ — **A4**

i = m

**B** — Détermination fonction: $\tau = f_1(\Delta n)$

**C** — Calcul des temps de vie corrigé $\tau_{ci}$, pour chaque I$_i$

**D** — Détermination fonction: $\tau_c = f_2(\Delta n)$

Figure 3

[Fig. 4]

Figure 4

[Fig. 5]

Figure 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2013122612 A1

**Littérature non-brevet citée dans la description**

- **T.S. HORANYI et al.** *Appl. Surf. Sci.*, 1993, vol. 63, 306-311
- **G.D. JENKINS et al.** *Proc. SPIE*, 2015, 9226
- **CHOI KWAN BUM et al.** Modulated Photoluminescence Lifetime Measurement of Bifacial Solar Cells. *IEEE Journal of Photovoltaics*, vol. 7 (6), 1
- Modulated photoluminescence as an effective lifetime measurement method: Application to a-Si:H/c-Si heterojunction solar cells. **CHOUFFOT R et al.** Materials Science and Engineering: B. ELSEVIER, vol. 159-160
- Understanding and resolving the discrepancy between differential and actual minority carrier lifetime. **GIESECKE J A et al.** Journal of Applied Physics. American Institute of Physics, vol. 113
- **R. BRUGGEMANN et al.** *J. Non-Cryst. Solids*, 2006, vol. 352, 188861891